Europäisches Patentamt

European Patent Office

Office européen des brevets

(11) EP 0 826 978 A1

(19) 

(12) **EUROPEAN PATENT APPLICATION**

(43) Date of publication:
04.03.1998 Bulletin 1998/10

(51) Int Cl.⁶: **G01R 33/3815**, G01R 33/3875, G01R 33/3873

(21) Application number: 97306475.1

(22) Date of filing: 26.08.1997

(84) Designated Contracting States:
**AT BE CH DE DK ES FI FR GB GR IE IT LI LU MC NL PT SE**
Designated Extension States:
**AL LT LV RO SI**

(30) Priority: **26.08.1996 US 697516**

(71) Applicant: **GENERAL ELECTRIC COMPANY Schenectady, NY 12345 (US)**

(72) Inventors:
• **Dorri, Bizhan Clifton Park, New York 12065 (US)**
• **Laskaris, Evangelos Trifon Schenectady, New York 12309 (US)**
• **Ogle, Michele Dollar Burnt Hills, New York 12027 (US)**

(74) Representative: **Goode, Ian Roy et al London Patent Operation General Electric International, Inc., Essex House, 12-13 Essex Street London WC2R 3AA (GB)**

(54) **Closed MRI magnet having compact design**

(57) A closed magnetic resonance imaging (MRI) magnet (110) has a single superconductive coil assembly (112) including a coil housing (114) containing a pair of superconductive main coils (128, 130), a pair of superconductive bucking coils (136, 138) carrying electric current in a direction opposite to that of the main coils and positioned longitudinally between the main coils at roughly the same radial distance as the main coils, and at least one additional superconductive main coil (146, 148) carrying electric current in the same direction as the main coils and positioned longitudinally between the bucking coils. The coil arrangement allows the design of a shorter MRI magnet.

FIG.1

EP 0 826 978 A1

# Description

The present invention relates generally to a closed superconductive magnet (such as, but not limited to, a helium-cooled and/or cryocooler-cooled superconductive magnet) used to generate a high magnetic field as part of a magnetic resonance imaging (MRI) system, and more particularly to such a magnet having a compact design and having a homogeneous (i.e., uniform) magnetic field within its imaging volume.

MRI systems employing superconductive or other type magnets are used in various fields such as medical diagnostics. Known superconductive magnets include liquid-helium cooled and cryocooler-cooled superconductive magnets. Typically, for a helium-cooled magnet, the superconductive coil assembly includes a superconductive main coil which is at least partially immersed in liquid helium contained in a helium dewar which is surrounded by a dual thermal shield which is surrounded by a vacuum enclosure. In a conventional cryocooler-cooled magnet, the superconductive main coil is surrounded by a thermal shield which is surrounded by a vacuum enclosure, and the cryocooler coldhead is externally mounted to the vacuum enclosure with the coldhead's first stage in thermal contact with the thermal shield and with the coldhead's second stage in thermal contact with the superconductive main coil. Nb-Ti superconductive coils typically operate at a temperature of generally 4 Kelvin, and Nb-Sn superconductive coils typically operate at a temperature of generally 10 Kelvin.

Known superconductive magnet designs include closed magnets and open magnets. Closed magnets typically have a single, tubular-shaped superconductive coil assembly having a bore. The superconductive coil assembly includes several radially-aligned and longitudinally spaced-apart superconductive main coils each carrying a large, identical electric current in the same direction. The superconductive main coils are thus designed to create a magnetic field of high uniformity within a spherical imaging volume centered within the magnet's bore where the object to be imaged is placed.

Although the magnet is so designed to have a highly uniform magnetic field within the imaging volume, manufacturing tolerances in the magnet and magnetic field disturbances caused by the environment at the field site of the magnet usually require that the magnet be corrected at the field site for such minor irregularities in the magnetic field. Typically, the magnet is shimmed at the field site by using pieces of iron, or, for Nb-Ti superconductive magnets cooled by liquid helium, by using numerous Nb-Ti superconductive correction coils. The correction coils are placed within the superconductive coil assembly radially near and radially inward of the main coils. Each correction coil carries a different, but low, electric current in any required direction including a direction opposite to the direction of the electric current carried in the main coils. It is also known to shim a closed magnet by using numerous resistive DC shim coils all located outside the vacuum enclosure (i.e., coil housing) in the bore. The resistive DC shim coils each produce time-constant magnetic fields and may include a single shim coil coaxially aligned with the longitudinal axis and carrying an electric current in a direction opposite to the current direction of the superconductive main coils to correct a harmonic of symmetrical inhomogeneity in the magnetic field within the imaging volume caused by manufacturing tolerances and/or site disturbances. It is noted that time-varying-magnetic-field gradient coils typically are placed in the magnet's bore for MRI imaging.

Closed MRI magnets tend to have a relatively long axial (i.e., longitudinal) length to accommodate the number of main superconductive coils needed to achieve a homogeneous imaging volume which, especially in the case of whole-body magnets, tends to create claustrophobic feelings in patients.

Open magnets typically employ two spaced-apart superconductive coil assemblies with the open space between the assemblies allowing for access by medical personnel for surgery or other medical procedures during MRI imaging. The patient may be positioned in that space or also in the bore of the toroidal-shaped coil assemblies. The open space helps the patient overcome any feelings of claustrophobia that may be experienced in a closed magnet design. Open magnets are known which use superconductive bucking coils radially inward from the superconductive main coils to correct for gross distortions in the magnetic field within the imaging volume created by having the open space between the superconductive coil assemblies. Such bucking coils have electric currents with generally the same amperage but the opposite direction to the electric current carried by the main coils. It is noted the open magnets are more expensive than closed magnets for the same strength magnetic field within the imaging volume.

What is needed is a closed MRI magnet which is designed to have a relatively short axial (i.e., longitudinal) length to overcome claustrophobic feelings of patients and to provide at least some patient access by physicians and which is designed to have a highly uniform magnetic field within its imaging volume to provide for sharp medical images.

It is an object of the invention to provide a closed superconductive MRI magnet which meets these needs.

The closed MRI magnet of the invention has a single superconductive coil assembly including a generally toroidal-shaped coil housing surrounding a bore and having a generally longitudinally-extending axis. The single superconductive coil assembly also includes a pair of longitudinally-spaced-apart, generally identical, and generally annular-shaped superconductive main coils each generally coaxially aligned with the axis, each having a generally identical inner radius and a generally identical outer radius, each carrying a generally identical first electric current in an identical first electric-current direction, and each located within the coil housing. The single superconductive coil assembly further includes a pair of longitudinally-spaced-apart, generally identical, and generally annular-shaped superconductive bucking coils each generally coaxially aligned with the axis, each having a generally identical inside radius and a generally identical outside radius, each carrying a generally identical second electric current in an opposite direction to the first electric-current direction, and each located within the coil housing longitudinally between the pair of superconductive main coils. At least one of the inside and outside radii of the pair of superconductive bucking coils has a value between generally the inner radius and generally the difference between the inner radius and twice the outer radius of the pair of superconductive main coils. In a preferred embodiment, at least one of the inside and outside radii has a value between generally the inner radius and generally the outer radius. In an exemplary embodiment, each of the inside and outside radii has a value between generally the inner radius and generally the outer radius. The single superconductive coil assembly additionally includes at least one generally annular-shaped additional superconductive main coil generally coaxially aligned with the axis, carrying a third electric current in the first electric-current direction, and located within the coil housing longitudinally between the pair of superconductive bucking coils.

Several benefits and advantages are derived from the invention. With Applicant's closed MRI magnet design, the overall axial (i.e., longitudinal) length of, for example, a whole-body magnet may be shortened by using magnetic field analysis to choose the superconductive bucking coils to overcome the gross magnetic field distortions within the imaging volume (created when longitudinally outer superconductive main coils are moved axially inward to shorten the axial length of the closed magnet) to produce a magnetic field of high uniformity within the imaging volume. Applicant's highly uniform magnetic field permits high quality MRI imaging. Applicant's shorter closed magnet design eliminates or reduces any claustrophobic feelings of patients. By locating the superconductive bucking coils and the superconductive main coils at roughly the same radial distance from the axis of the coil housing, a more compact magnet design is achieved which requires less superconductor in the main coils for a given magnetic field strength than would be required if the bucking coils were located radially inward from the main coils.

The accompanying drawings illustrate several preferred embodiments of the present invention wherein:

Figure 1 is a schematic cross-sectional side-elevational view of a first preferred embodiment of the closed MRI magnet of the invention having a pair of generally-non-permanently-magnetized ferromagnetic rings located outside the coil housing in the bore;

Figure 2 is an end view of the magnet of Figure 1 taken along the lines 2-2 of Figure 1;

Figure 3 is an end view of one of the pair of superconductive main coils of Figure 1;

Figure 4 is an end view of one of the pair of superconductive bucking coils of Figure 1; and

Figure 5 is a view, as in Figure 1, but of a second preferred embodiment of the closed MRI magnet of the invention having a pair of generally annular-shaped permanent magnet arrays located outside the coil housing in the bore.

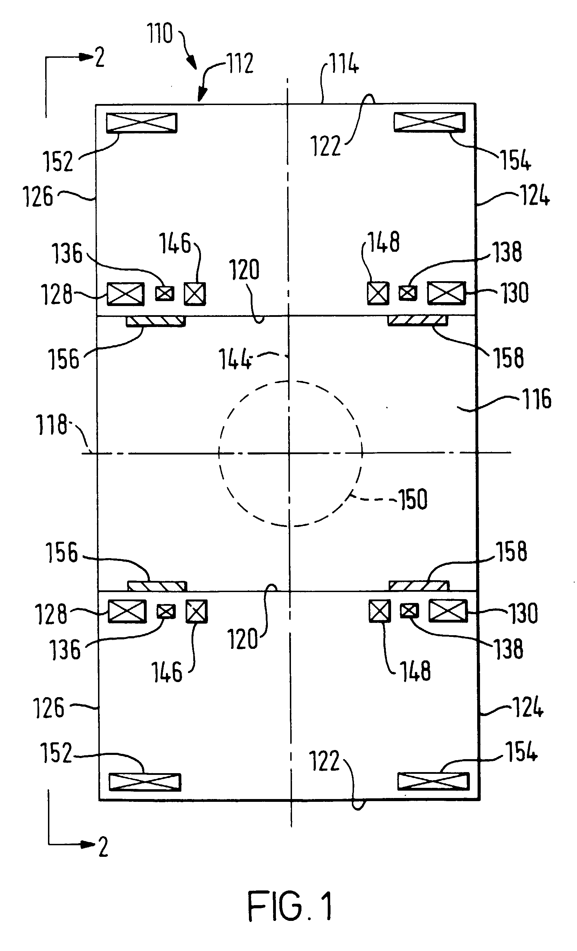

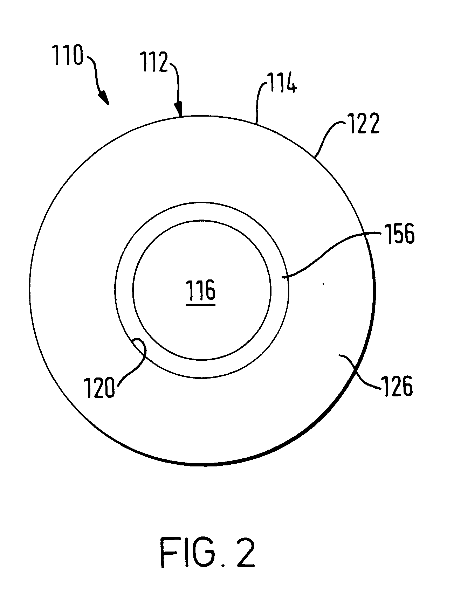

Referring now to the drawings Figures 1 and 2 show a first preferred embodiment of the closed magnetic-resonance-imaging (MRI) magnet 110 of the present invention. The magnet 110 has a single superconductive coil assembly 112. The single superconductive coil assembly 112 includes a generally toroidal-shaped coil housing 114 surrounding a bore 116 and having a generally longitudinally-extending axis 118. The coil housing 114 includes a first circumferential outside surface 120 facing generally towards the axis 118 and a second circumferential outside surface 122 radially spaced apart from the first circumferential outside surface 120 and facing generally away from the axis 118. The coil housing 114 also includes spaced-apart longitudinally-outermost ends 124 and 126. Each of the longitudinally-outermost ends 124 and 126 preferably is a generally-annular outside surface. Typically, the coil housing 114 defines a vacuum enclosure.

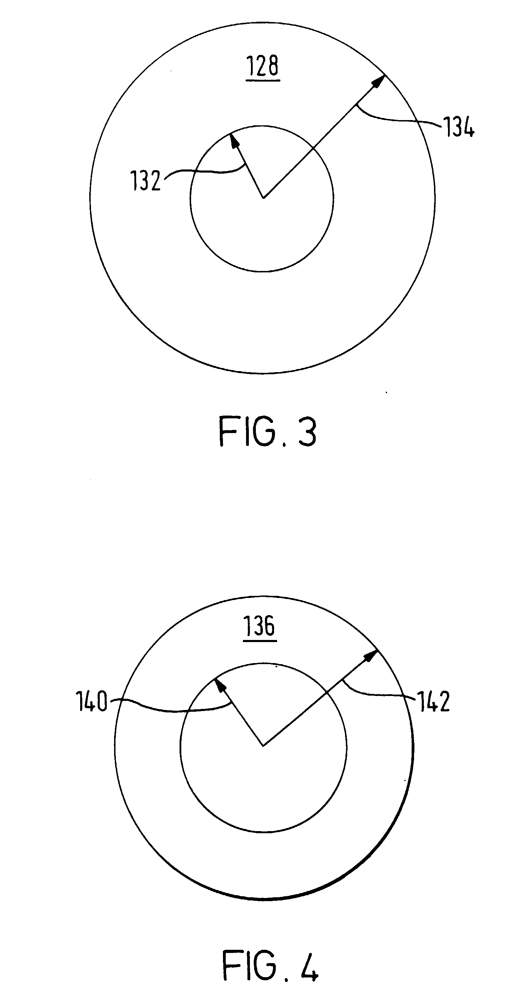

The single superconductive coil assembly 112 also includes a pair of longitudinally-spaced-apart, generally identical, and generally annular-shaped superconductive main coils 128 and 130. The pair of superconductive main coils 128 and 130 is conventionally supported (with such support omitted from the figures for clarity). Each of the pair of superconductive main coils 128 and 130 is a DC (direct current) coil having a generally time-constant operating current. Each of the pair of superconductive main coils 128 and 130 is generally coaxially aligned with the axis 118, is disposed within the coil housing 114, has a generally identical inner radius $R_i$ 132 and a generally identical outer radius $R_o$ 134 (as shown in Figure 3), and carries a generally identical first electric current in an identical first electric-current direction. The first electric-current direction is defined to be either a clockwise or a counterclockwise circumferential direction about the axis 118 with any slight longitudinal component of current direction being ignored. Hence, each of the pair of superconductive main coils 128 and 130 produce generally time-constant and generally identical magnetic fields which have a generally identical first magnetic-field direction within the bore 116 which is generally parallel to the axis 118.

Preferably, the pair of superconductive main coils 128 and 130 is a longitudinally-outermost (i.e., longitudinally-furthest-apart) pair of superconductive main coils disposed longitudinally proximate the longitudinally-outermost ends 124 and 126 and radially proximate the first circumferential outside surface 120 of the coil housing 114. The superconductor used in each of the superconductive main coils 128 and 130 typically would be a superconductive wire or superconductive tape wound such that each superconductive main coil 128 and 130 has a longitudinal extension and a radial extension (i.e., radial thickness) far greater than the corresponding dimensions of the superconductive wire or superconductive tape.

The single superconductive coil assembly 112 additionally includes a pair of longitudinally-spaced-apart, generally identical, and generally annular-shaped superconductive bucking coils 136 and 138 each of which is a DC (direct current) coil having a generally time-constant operating current. Each of the pair of superconductive bucking coils 136 and 138 is generally coaxially aligned with the axis 118, is disposed within the coil housing 114 longitudinally between the pair of superconductive main coils 128 and 130, has a generally identical inside radius $r_i$ 140 and a generally identical outside radius $r_o$ 142 (as shown in Figure 4), and carries a generally identical second electric current in an opposite direction to the first electric-current direction.

At least one of the inside and outside radii $r_i$ 140 and $r_o$ 142 of each of the pair of superconductive bucking coils 136 and 138 has a value between generally the inner radius $R_i$ 132 and generally the difference between the inner radius $R_i$ 132 and twice the outer radius $R_o$ 134 of the pair of superconductive main coils 128 and 130. Mathematically stated, for each of the pair of superconductive bucking coils 136 and 138, it is generally true that:

$$R_i < r_i < (2R_o - R_i),$$

and/or

$$R_i < r_o < (2R_o - R_i).$$

By generally true is meant that each "less than" symbol "<" should be read as "less than or equal to". In a preferred embodiment, at least one of the inside and outside radii $r_i$ 140 and $r_o$ 142 of each of the pair of superconductive bucking coils 136 and 138 has a value between generally the inner radius $R_i$ 132 and generally the outer radius $R_o$ 134 of the pair of superconductive main coils 128 and 130. Mathematically stated, for each of the pair of superconductive bucking coils 136 and 138 in such preferred embodiment, it is generally true that:

$$R_i < r_i < R_o,$$

and/or

$$R_i < r_o < R_o.$$

In an exemplary embodiment, each of the inside and outside radii $r_i$ 140 and $r_o$ 142 of each of the pair of superconductive bucking coils 136 and 138 has a value between generally the inner radius $R_i$ 132 and generally the outer radius $R_o$ 134 of the pair of superconductive main coils 128 and 130. Mathematically stated, for each of the pair of superconductive bucking coils 136 and 138 in such exemplary embodiment, it is generally true that:

$$R_i < r_i < R_o,$$

and

$$R_i < r_o < R_o.$$

It is noted that the pair of superconductive bucking coils 136 and 138 produce generally time-constant and generally identical magnetic fields which have a magnetic field direction within the bore 116 which is generally opposite to the first magnetic-field direction. The ampere-turns of each of the pair of superconductive bucking coils 136 and 138 typically is less than the ampere-turns of each of the pair of superconductive main coils 128 and 130. Desirably, the ampere-turns of each of the pair of superconductive bucking coils 136 and 138 is at least equal to generally 5% of the ampere-turns of all of the superconductive main coils in the coil housing 114. Preferably, the pair of superconductive bucking coils 136 and 138 each is longitudinally disposed a generally identical distance from a plane 144 which is oriented perpendicular to the axis 118 and which is disposed longitudinally midway between the pair of superconductive main coils 128 and 130. In an exemplary construction, the first and second electric currents are generally equal in amperage.

It is preferred that the longitudinally-outermost ends 124 and 126 of the coil housing 114 are longitudinally disposed a generally identical distance from the plane 144. It is noted that such longitudinally-outermost ends 124 and 126 desirably are generally-annular outside surfaces facing generally away from (and preferably aligned parallel with) the plane 144. The first circumferential outside surface 120 defines the radial extent of the bore 116 of the coil housing 114. In an exemplary construction, the bore 116 has a radius which remains constant as one moves longitudinally from one to the other of the longitudinally-outermost ends 124 and 126 of the coil housing 114.

The single superconductive coil assembly 112 further includes at least one generally annular-shaped additional superconductive main coil 146 and 148 (only two of which are shown in Figure 1) generally coaxially aligned with the axis, carrying a third electric current in the first electric-current direction, and disposed within the coil housing 114 longitudinally between the pair of superconductive bucking coils 136 and 138. The additional superconductive main coils 146 and 148 are needed to achieve a high magnetic field strength, within the magnet's imaging volume, without exceeding the critical current density of the superconductor being used in the coils, as is known to those skilled in the art. It is noted that the at least one additional superconductive main coil 146 and 148 is radially disposed with respect to the pair of superconductive main coils 128 and 130 in the same manner as the pair of superconductive bucking coils 136 and 138 is radially disposed with respect to the pair of superconductive main coils 128 and 130. In an exemplary construction, the first and third electric currents are generally equal in amperage. Preferably, the pair of superconductive bucking coils 136 and 138 is disposed longitudinally closer to the longitudinally-outermost ends 124 and 126 of the coil housing 114 than to the plane 144.

The pair of superconductive main coils 128 and 130 (together with the at least one additional superconductive main coil 146 and 148) typically produce, as designed by the artisan, a generally spherical (as shown in Figure 1), generally ellipsoidal, generally cylindrical or other-shaped imaging volume 150 (shown as a dotted image in Figure 1) typically centered generally at the intersection of the plane 144 and the axis 118. A closed MRI magnet which is designed to have a relatively short axial (i.e., longitudinal) length to overcome claustrophobic feelings of patients must longitudinally relocate the superconductive main coils closer to the plane 144 than usual to achieve its short length. The effect of such coil relocation is to distort the uniformity of the magnetic field of the imaging volume 150. The pair of bucking coils 136 and 138 is designed and positioned, using the principles of the present invention, previously disclosed herein, together with conventional magnetic field analysis, as is within the skill of the artisan, to produce a highly homogeneous magnetic field within the imaging volume 150 for improved MRI imaging. Applicants were surprised to find (from the results of computer simulations) that the superconductive bucking coils 136 and 138 did not have to be placed radially inward of the superconductive main coils 128 and 130, but could be radially disposed roughly the same distance from the axis 118 as the superconductive main coils 128 and 130 (as expressed by the previously-given three sets of equations). By locating the superconductive bucking coils 136 and 138 and the superconductive main coils 128 and 130 (and the at least one additional superconductive main coil 146 and 148) at roughly the same radial distance from the axis 118 of the coil housing 114, a more compact magnet design is achieved which requires less superconductor in the main coils 128 and 130 (and additional main coils 146 and 148) for a given magnetic field strength than would be required if the bucking coils 136 and 138 were located radially inward from the main coils 128 and 130 (and from the additional main coils 146 and 148). It is noted that without having additional main coils 146 and 148 which are positioned longitudinally between the bucking coils 136 and 138 or without having the pair of superconductive bucking coils 136 and 138 disposed longitudinally closer to the longitudinally-outermost ends 124 and 126 of the coil housing 114 than to the plane 144, the magnet 110 would have a high magnetic field inhomogeneity unsuitable for MRI medical imaging.

In certain applications, it is desirable that the single superconductive coil assembly 112 also include a pair of longitudinally-spaced-apart, generally identical, and generally annular-shaped superconductive shielding coils 152 and 154 each generally coaxially aligned with the axis 118, each carrying a generally identical second electric current in the opposite direction to the first electric-current direction, and each disposed within the coil housing 114 radially outward from the pair of superconductive main coils 128 and 130. The effect of the shielding coils 152 and 154 is to minimize any magnetic field leakage from interfering with any nearby electronic equipment, and their design and positioning is within the skill of the artisan using the principles of the present invention, previously disclosed herein, together with conventional magnetic field analysis.

The cooling of the superconductive main coils 128 and 130, the superconductive bucking coils 136 and 138, the at least one additional superconductive main coil 146 and 148, and the superconductive shielding coils 152 and 154 may be accomplished by any means and do not form a part of this invention. Examples of conventional cooling include cooling by a cryogenic fluid (e.g., liquid helium) and/or a cryocooler. Details of such cooling (including, but not limited to, dewars, thermal shields, cryocooler coldheads, etc.) have been omitted from the figures for clarity.

In the first preferred embodiment shown in Figures 1 and 2, the magnet 110 also includes a pair of longitudinally-spaced-apart, generally identical, and generally-non-permanently-magnetized ferromagnetic rings 156 and 158 each generally coaxially aligned with the axis 118 and each disposed radially inward of the pair of superconductive main coils 128 and 130 and the superconductive bucking coils 136 and 138. The pair of ferromagnetic rings 156 and 158 is designed to augment the pair of bucking coils 136 and 138, using the principles of the present invention, previously disclosed herein, together with conventional magnetic field analysis, as is within the skill of the artisan, to produce a highly homogeneous magnetic field within the imaging volume 150 for improved MRI imaging. The ferromagnetic rings 156 and 158 may be located inside the coil housing or, as shown in Figure 1, outside the coil housing 114.

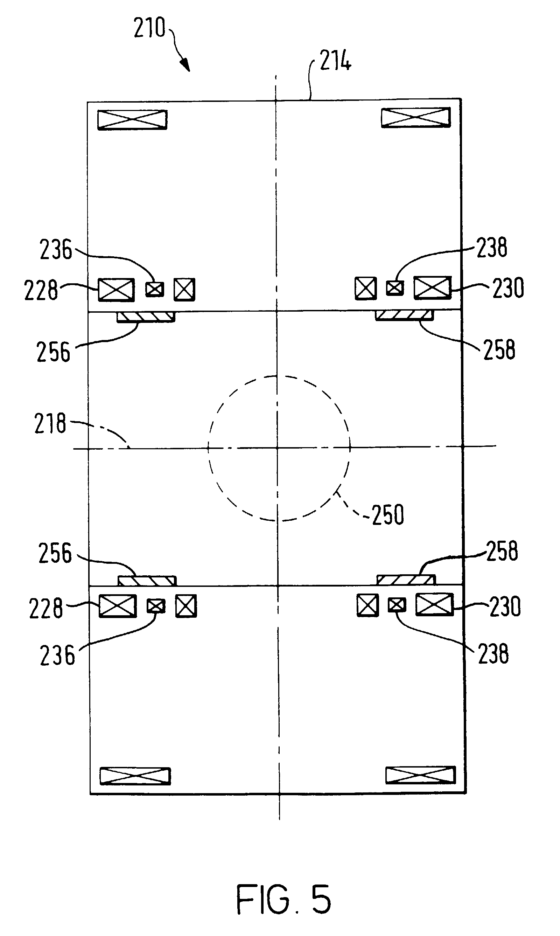

Referring again to the drawings, Figure 5 shows a second preferred embodiment of the closed magnetic resonance imaging (MRI) magnet 210 of the present invention. Magnet 210 is similar to magnet 110 of the first preferred embodiment of the invention, with differences as hereinafter noted. In magnet 210, the pair of ferromagnetic rings 156 and 158 is replaced with a pair of permanent magnet arrays 256 and 258. Thus, magnet 210 includes a pair of longitudinally-spaced-apart, generally identical, and generally annular-shaped permanent magnet arrays 256 and 258 each generally coaxially aligned with the axis 218 and each disposed radially inward of the pair of superconductive main coils 228 and 230 and the pair of superconductive bucking coils 236 and 238. The pair of permanent magnet arrays 256 and 258 is designed to augment the pair of bucking coils 236 and 238, using the principles of the present invention, previously disclosed herein, together with conventional magnetic field analysis, as is within the skill of the artisan, to produce a highly homogeneous magnetic field within the imaging volume 250 for improved MRI imaging. The permanent magnet arrays 256 and 258 may be located inside the coil housing or, as shown in Figure 5, outside the coil housing 214.

Applicants have used computer analysis to verify the magnet-shortening effect of using the previously-described superconductive bucking coils. In an example, a spherical imaging volume was achieved having 1.5-Tesla magnetic field strength, a 45-centimeter-diameter, and a 7.5 parts-per-million peak-to-peak magnetic field inhomogeneity. The coil-housing length was generally 140 centimeters with the bucking coils located at generally the same radial distance as the superconductive main coils. For similar imaging volume performance, this compares to an estimated coil-housing length of generally 150 centimeters for a magnet design with the bucking coils located radially inward of the main coils and compares to an estimated coil-housing length of generally 170 centimeters for a magnet design which does not use any bucking coils.

## Claims

1. A closed magnetic-resonance-imaging magnet comprising a single superconductive coil assembly including:

a) a generally toroidal-shaped coil housing surrounding a bore and having a generally longitudinally-extending axis;

b) a pair of longitudinally-spaced-apart, generally identical, and generally annular-shaped superconductive main coils each generally coaxially aligned with said axis, each having a generally identical inner radius and a generally identical outer radius, each carrying a generally identical first electric current in an identical first electric-current direction, and each disposed within said coil housing;

c) a pair of longitudinally-spaced-apart, generally identical, and generally annular-shaped superconductive bucking coils each generally coaxially aligned with said axis, each having a generally identical inside radius and a generally identical outside radius, each carrying a generally identical second electric current in an opposite direction to said first electric-current direction, and each disposed within said coil housing longitudinally between said pair of superconductive main coils, wherein at least one of said inside and outside radii has a value between generally said inner radius and generally the difference between said inner radius and twice said outer radius; and

d) at least one generally annular-shaped additional superconductive main coil generally coaxially aligned with said axis, carrying a third electric current in said first electric-current direction, and disposed within said coil housing longitudinally between said pair of superconductive bucking coils.

2. The magnet of claim 1, wherein said pair of superconductive bucking coils each is longitudinally disposed a generally identical distance from a plane which is oriented perpendicular to said axis and which is disposed longitudinally midway between said pair of superconductive main coils.

3. The magnet of claim 2, wherein said pair of superconductive bucking coils is disposed longitudinally closer to said longitudinally-outermost ends of said coil housing than to said plane.

4. The magnet of claim 3, wherein said first, second, and third electric currents are generally equal in amperage.

5. The magnet of claim 4, wherein at least one of said inside and outside radii has a value between generally said inner radius and generally said outer radius.

6. The magnet of claim 5, wherein each of said inside and outside radii has a value between generally said inner radius and generally said outer radius.

7. The magnet of claim 6, wherein said pair of superconductive main coils is a pair of longitudinally outermost superconductive main coils.

8. The magnet of claim 4, also including a pair of longitudinally-spaced-apart, generally identical, and generally-non-permanently-magnetized ferromagnetic rings each generally coaxially aligned with said axis and each disposed radially inward of said pair of superconductive main coils and said pair of superconductive bucking coils.

9. The magnet of claim 4, also including a pair of longitudinally-spaced-apart, generally identical, and generally annular-shaped permanent magnet arrays each generally coaxially aligned with said axis and each disposed radially inward of said pair of superconductive main coils and said pair of superconductive bucking coils.

10. The magnet of claim 1, wherein said single superconductive coil assembly also includes a pair of longitudinally-spaced-apart, generally identical, and generally annular-shaped superconductive shielding coils each generally coaxially aligned with said axis, each carrying a generally identical second electric current in said opposite direction, and each disposed within said coil housing radially outward from said pair of superconductive main coils.

FIG.1

FIG. 2

FIG. 3

FIG. 4

FIG. 5

**European Patent Office**

**EUROPEAN SEARCH REPORT**

Application Number

EP 97 30 6475

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 496 368 A (TOKYO SHIBAURA ELECTRIC CO) 29 July 1992<br>* column 2, line 27 - column 4, line 17 *<br>* column 4, line 58 - column 6, line 15; figures 1,2 * | 1-7 | G01R33/3815<br>G01R33/3875<br>G01R33/3873 |
| Y | | 8-10 | |
| Y | GB 2 295 672 A (OXFORD MAGNET TECH) 5 June 1996<br>* page 2, line 10 - page 2, line 27 *<br>* page 5, line 25 - page 7, line 17; figures 1,2 * | 8,10 | |
| Y | EP 0 216 404 A (PHILIPS NV) 1 April 1987<br>* page 3, line 6 - page 3, line 30 *<br>* page 4, line 24 - page 6, line 5 *<br>* page 8, line 1 - page 8, line 24; figures 1,2 * | 9 | |
| A | EP 0 414 528 A (GEN ELECTRIC) 27 February 1991<br>* page 2, line 1 - page 2, line 38 *<br>* page 3, line 17 - page 4, line 5; figure 2 * | 8 | TECHNICAL FIELDS SEARCHED (Int.Cl.6)<br><br>G01R |

The present search report has been drawn up for all claims

| Place of search | Date of completion of the search | Examiner |
|---|---|---|
| MUNICH | 15 October 1997 | Lersch, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)